# EUROPEAN PATENT APPLICATION

(11) **EP 3 751 018 A1**
(43) Date of publication of application: **16.12.2020**
(21) Application number: 18904550.3
(22) Date of filing: 29.05.2018
(51) Int. Cl.: C23C 16/455, C23C 16/513

(54) **VACUUM REACTION DEVICE AND REACTION METHOD**

(30) Priority: 06.02.2018 CN 201810116519
(71) Applicant: Jiangsu Leadmicro Nano-Equipment Technology Ltd., Wuxi, Jiangsu 214028 (CN)
(72) Inventor: LI, Weiming, Wuxi, Jiangsu 214028 (CN); LI, Xiang, Wuxi, Jiangsu 214028 (CN); Zhang, He, Wuxi, Jiangsu 214028 (CN); ZUO, Min, Wuxi, Jiangsu 214028 (CN); YAO, Liang, Wuxi, Jiangsu 214028 (CN)
(74) Representative: Michalski Hüttermann & Partner Patentanwälte mbB
(86) International application number: PCT/CN2018/088804
(87) International publication number: WO 2019/153585

(57) **Abstract**

Disclosed is a vacuum reaction device: a heater (7) is disposed at the exterior of a reaction chamber (6); a carrier (8) is placed within the reaction chamber (6), and the carrier (8) is electrically conductive and is insulated from other portions within the reaction chamber (6); the carrier (8) is at least one set of plates arranged in parallel, two adjacent plates being connected to two poles of a plasma power source (9) respectively; when a plurality of sets of plates arranged in parallel are provided, the parallel plates are alternately connected to each other by means of conductive elements and are led out of the vacuum chamber, being connected to the two poles of the plasma power source (9) respectively; an end of the reaction chamber (6) is provided with a gas outlet, the gas outlet being connected to a vacuum pump (10), while the other end is provided with a gas inlet, the gas inlet being connected to a gas source. Also disclosed are a reaction chamber used for a vacuum reaction device, a vacuum reaction device-based plasma-enhanced atomic layer deposition coating method, and a vacuum reaction device-based plasma-enhanced chemical vapor deposition coating method.

## Description

### TECHNICAL FIELD

The present disclosure relates to a vacuum preparation for thin film material, and particularly relates to a plasma-enhanced atomic layer deposition apparatus, a plasma-enhanced chemical vapor deposition apparatus and reaction methods thereof.

### BACKGROUND

Plasma-enhanced atomic layer deposition (PEALD) has following synonyms: plasma-assisted atomic layer deposition (PAALD), plasma atomic layer deposition (plasma ALD), or radical-enhanced atomic layer deposition (radical-enhanced ALD). Although their names are different due to historical reasons, the processes for processing the silicon wafer thereof are virtually identical, and thus they belong to the same method. The name "PEALD" is used herein, however other names should be covered by the present disclosure.

ALD refers to atomic layer deposition and CVD refers to chemical vapor deposition.

The plasma-enhanced atomic layer deposition (PEALD) vacuum coating technology has been widely used in the semiconductor and photovoltaic fields, which can deposit a variety of semiconductor or metal thin films and accurately control the thin films to a sub-nanometer level. The use of a plasma power supply allows the thin films deposited by the PEALD technology to have variable material properties and can be used in a variety of applications. Currently, the PEALD apparatuses are limited to small-sized apparatuses which can process only one or several silicon wafers at one time, thereby limiting productivity and increasing preparation costs.

### SUMMARY

In order to solve the problems existing in the prior art, the present disclosure discloses a vacuum reaction device and a method thereof.

### I. a technical solution for the vacuum reaction device is set forth as follows:

a reaction chamber of a vacuum reaction device is externally provided with a heater. Preferably, the heater is a resistance wire heater that heats the reaction chamber, and heat radiation heats a silicon wafer on a carrier disposed in the furnace body, to control a temperature of the surface of the silicon wafer while depositing a thin film. The carrier is disposed in the reaction chamber, and is electrically conductive and insulated from other portions in the reaction chamber. The carrier is at least one set of plates arranged in parallel, and adjacent plates are connected to two poles of a plasma power supply, respectively. If a plurality of sets of parallel plates are provided, the parallel plates are alternately connected to each other and are led out of the reaction chamber. The odd plates are connected to each other to form an electrode, and the even plates are connected to each other to form another electrode. The two electrodes are led out of the reaction chamber via conductive wires and are respectively connected to two poles of the plasma power supply.

A preferred technical solution for the parallel plates is that all parallel plates are vertically connected at four apex corners of the plates via insulated straight bars that are through the plates. Adjacent plates are insulated by insulation pads through which the straight bars extend, and alternating plates are connected to each other at one end of the plates via a conductive material.

A sheet-shape material to be coated, such as a silicon wafer, can be disposed on the surfaces of the set of the parallel plates. One silicon wafer can be disposed on each side of both sides of each plate, respectively, and the plates may be relatively wide so that a surface of the plates can carry a plurality of silicon wafers on the same plane.

One end of the reaction chamber is provided with a gas outlet connected to a vacuum pump which vacuums the reaction chamber to keep the chamber vacuum, and another end of the reaction chamber is provided with a gas inlet connected to a gas source.

The reaction chamber of the vacuum reaction device can be applied to both a plasma-enhanced atomic layer deposition reaction and a plasma-enhanced chemical vapor deposition reaction. The technical solution for the reaction chamber of the present disclosure relates to an apparatus compatible for atomic layer deposition and chemical vapor deposition in the vacuum reaction device, in which both atomic layer deposition and coating can occur in the reaction chamber and chemical vapor deposition and coating can occur in the reaction chamber.

The gas source includes a reaction gas, a vapor of a chemical source and a carrier gas. The above-mentioned gas can be connected to the gas inlet in a variety of ways (Here, a gas connection refers to a connection of a container with gas, a pipeline, and a control valve to the gas inlet, which is simply as a connection of a gas to the gas inlet for the sake of brevity). Different coating reactions require for different reaction gases and chemical sources. Different coating reactions may require for several reaction gases or different coating reactions may require for several chemical sources, which are adjusted in actual reactions according to requirements:
(1) The reaction gas, the vapor of the chemical source and the carrier gas are connected to the gas inlet, respectively;
(2) The vapor of the chemical source and the reaction gas are connected to the gas inlet, respectively. The carrier gas is connected to the vapor of the chemical source and carries the vapor of the chemical source into the reaction chamber;
(3) The reaction gas, the vapor of the chemical source and the carrier gas are connected to the gas inlet, respectively, while the carrier gas is connected to the vapor of the chemical source. One part of the carrier gas carries the vapor of the chemical source into the reaction chamber and another part of the carrier gas directly enters the reaction chamber.

A first valve is arranged between the gas inlet of the reaction chamber and the chemical source. A second valve is arranged between the chemical source and the carrier gas. A third valve is arranged between the gas inlet of the reaction chamber and the carrier gas. A fourth valve is arranged between the gas inlet of the reaction chamber and a first reaction gas. The gas inlet of the reaction chamber is connected to a second reaction gas through a fifth valve. The most general arrangement for the chemical source, the carrier gas and the reaction gases is given above, and in practice, for each process, different chemical sources, carrier gases and reaction gases and respective quantities thereof may be arranged depending on specific process.

In the present technical solution, the reaction chamber of the vacuum reaction device may either perform the atomic layer deposition reaction therein as an atomic layer deposition apparatus or performed the chemical vapor deposition reaction therein as a vapor deposition apparatus. However, in the prior art, the atomic layer deposition apparatus and the chemical vapor deposition apparatus cannot be compatible.

### II. a plasma-enhanced atomic layer deposition and reaction method is set forth as follows:

The deposition method includes a plurality of identical cycles, each of which ensures an atomic layer of the deposited thin film material. The number of the cycles can be controlled to accurately control the thickness of the thin film.

In each cycle, there are four steps:

Step 1, the first valve and the second valve are opened to cause the carrier gas to flow through the chemical source and enter the reaction chamber, and a time of the chemical source entering the chamber (a pulse time of the chemical source) is controlled.

Step 2, the first valve and the second valve are closed, the third valve is opened, and then the carrier gas purges the reaction chamber.

Step 3, the fourth valve and/or the fifth valve are opened and the reaction gases are supplied, and then the plasma power supply is turned on for processing.

Step 4, the plasma power supply is turned off, the third valve is opened, and then the carrier gas purges the reaction chamber.

The carrier gas carries the chemical source in two ways: when the first valve and the second valve are opened, by controlling the third valve, the carrier gas may enter the chemical source entirely and then enter the reaction chamber, or one part of the carrier gas may enter the chemical source and another part of the carrier gas may directly enter the reaction chamber.

The chemical source enters the reaction chamber in three ways:
(1) The first valve is opened, and the chemical source enters the reaction chamber. In this way, the vapor of the chemical source entering the reaction chamber is a pure vapor of chemical source without the carrier gas, and the concentration of the chemical source is highest;
(2) The first valve and the second valve are opened, and the carrier gas enters the chemical source and carries the chemical source into the reaction chamber. In this way, the carrier gas carries the vapor of the chemical source into the reaction chamber and entirely enters the chemical source;
(3) The first valve, the second valve and the third valve are opened, and the carrier gas partly carries the chemical source into the reaction chamber or the carrier gas directly enters the reaction chamber through the third valve. In this way, although the carrier gas carries the vapor of the chemical source into the reaction chamber, only one part of the carrier gas enters the chemical source, and another part of the carrier gas directly enters the chamber.

After the chemical source enters the reaction chamber and reacts therein and the carrier gas purges the reaction chamber, the fourth valve and the fifth valve are opened, the first reaction gas and the second reaction gas enter the reaction chamber. The plasma power supply is turned on, and a plasma is generated between two parallel plates of the carrier, so that a chemical reaction between the reaction gases and a film layer of silicon wafer surface is excited.

### III. A plasma-enhanced chemical vapor deposition and reaction method is set forth as follows:

Simultaneously or separately supplying the chemical source and the reaction gas to the reaction chamber and turning on the plasma power supply to generate the plasma; supplying one part of the chemical source or the reaction gas to the reaction chamber and turning on the plasma power supply to generate the plasma, and then supplying another part of the chemical source or the reaction gas to the reaction chamber. Keeping a corresponding valve open and keeping the chemical source and the reaction gas continuously enter the reaction chamber, keeping the plasma power supply continuously on to ensure the plasma to continuously exist between the parallel carriers, and controlling a turn-on time of the plasma power supply to control a thin film thickness.

In an entire reaction cycle, the fourth valve and the fifth valve keep open and the plasma power supply keeps on throughout the entire reaction process. The first reaction gas and the second reaction gas react with the chemical source, and a chemical reaction occurs between the reaction gases.

The apparatus can prepare following compounds by the plasma-enhanced chemical vapor deposition process: aluminum oxide (AlOx), aluminum nitride (AlNx), aluminum oxynitride (AlOxNy), silicon nitride (SiNx), silicon oxide (SiOx), silicon oxynitride (SiOxNy), or the like.

The advantageous effects achieved by the present disclosure:
(1) The use of an insulated tubular furnace and the carrier capable of carrying a large number of silicon wafers in the present disclosure allows these silicon wafers on the carrier to be processed simultaneously at one time while maintaining a high uniformity of thickness of coated films in one wafer, between wafers, and between batches of wafers.
(2) The resulted atomic layer deposition films have the following advantages: 1) good film shape retention, 2) the thickness can be accurately controlled to a sub-nanometer level, 3) by contrast to the PECVD technology and the thermal ALD technology, the variety of the thin films to be deposited are richer, and the variable ranges of material property of the thin films are wider, suitable for a variety of applications, 4) by contrast to the PECVD technology, more chemical sources (such as trimethylaluminum TMA) can be saved.
(3) Meanwhile, the apparatus is also compatible with the plasma-enhanced chemical vapor deposition (PECVD) technology. The PEALD and PECVD technologies for processing silicon wafers can be implemented in sequence in the same chamber, which can significantly reduce the equipment investment of the semiconductor and photovoltaic manufacturers and reduce the cost of the silicon wafer fabrication.
(3) By contrast to the PEALD apparatus capable of processing only one or several silicon wafers at one time, since the use of the above-mentioned tubular furnace and the above-mentioned carrier, the apparatus of present disclosure can process a large number of (more than 400) silicon wafers simultaneously using the PEALD technology while being compatible with the PECVD process.

### BRIEF DESCRIPTION OF THE DRAWINGS

FIG. 1 is a schematic structural diagram of a vacuum reaction device;
FIG. 2 is a schematic cross-sectional diagram of a vacuum reaction device;
FIG. 3 is an operating diagram of a mode of each gas and chemical sources for the plasma-enhanced atomic layer deposition entering a chamber and a mode of feeding the plasma into the chamber; and
FIG. 4 is an operational diagram of a mode of each gas and chemical source for plasma-enhanced chemical vapor deposition entering a chamber and a mode of feeding the plasma into the chamber.

### DETAILED DESCRIPTION OF THE EMBODIMENTS

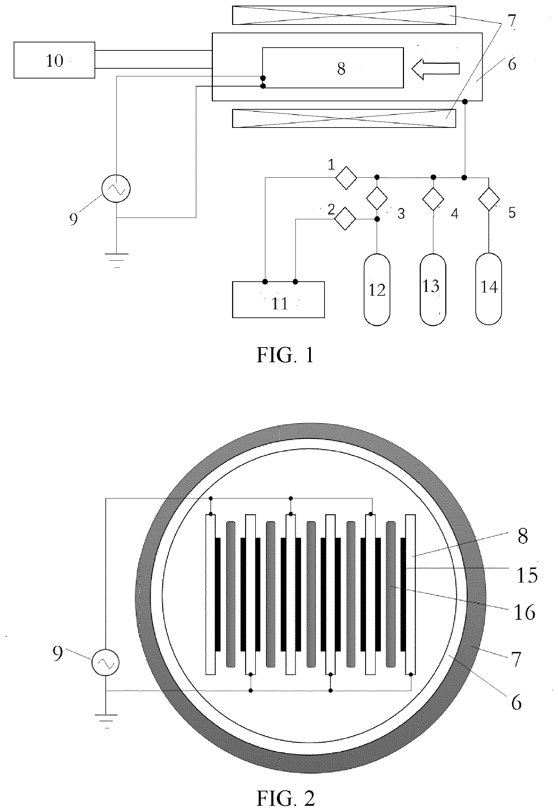

The present disclosure is further described below with reference to FIG. 1 to FIG. 3 and several embodiments.

### First embodiment

FIG. 1 is a schematic structural diagram of a vacuum reaction device, which includes a furnace body being a cylindrical reaction chamber 6 which is made of materials such as quartz, ceramics, or the like. The reaction chamber 6 has a diameter of between 300 mm and 500 mm and a length of between 2000 mm and 2500 mm.

The reaction chamber 6 is externally provided with a resistance wire heater 7, and the heat radiation of the resistance wire heater 7 heats a surface of a silicon wafer on a carrier disposed in the furnace body, to control a temperature of the surface of the silicon wafer while depositing a thin film. When implementing processes, a large number of carriers 8 are disposed in the reaction chamber 6, which carry objects to be coated, such as the silicon wafer or the like, therein. The carriers 8 are made of materials such as graphite, stainless steel, or the like, so that the carriers 8 can carry 240 to 416 silicon wafers each having an area of 156 mm × 156 mm. The carriers 8 are electrically conductive and insulated from other portions of the reaction chamber 6. Carriers 8 include a plurality of sets of plates arranged in parallel, which are alternately connected to each other and are led out of the reaction chamber, and connected to two poles of a plasma power supply 9, respectively. The reaction chamber 6 is provided with a gas outlet at one end, which is connected to a vacuum pump 10, and a gas inlet at another end, which is connected to a gas source. The arrow in FIG. 1 represents a direction of gas flow.

A first valve 1 is arranged between the gas inlet of the reaction chamber 6 and a chemical source 11. A second valve 2 is arranged between the chemical source 11 and a carrier gas 12. A third valve 3 is arranged between the gas inlet of the reaction chamber 6 and the carrier gas 12. A fourth valve 4 is arranged between the gas inlet of reaction chamber and a first reaction gas 13. The gas inlet of the reaction chamber is connected to a second reaction gas 14 through a fifth valve 5.

As shown in FIG. 1, the carrier gas which does not carry the chemical source can directly enter the reaction chamber 6 through the third valve 3. When the first valve 1 and the second valve 2 are opened, the carrier gas flows through a source bottle of the chemical source and can enter the reaction chamber together with the chemical source. The reaction gases may directly enter the reaction chamber through respective valves. Multiple reaction gases may be provided to prepare a ternary compound and a polycompound.

FIG. 2 is a schematic cross-sectional diagram of a vacuum reaction device, as shown, carriers 8 include a plurality of sets of plates arranged in parallel, and silicon wafers 15 are disposed on both sides of each plate, except for the outermost plates, in which silicon wafers 15 are only disposed on inner sides of the outermost plates.

The parallel plates are alternately connected to each other and are led out of the vacuum chamber, and connected to the two poles of the plasma power supply 9, respectively. The carriers 8 are disposed on the reaction chamber 6 and insulated from other portions in the furnace body. When implementing processes, a plasma 16 is generated between adjacent silicon wafers disposed on inner sides of adjacent plates. One end of the reaction chamber 6 is connected to a vacuum pump to maintain a vacuum therein. Another end of the reaction chamber 6 is supplied with a carrier gas, a chemical source and various reaction gases.

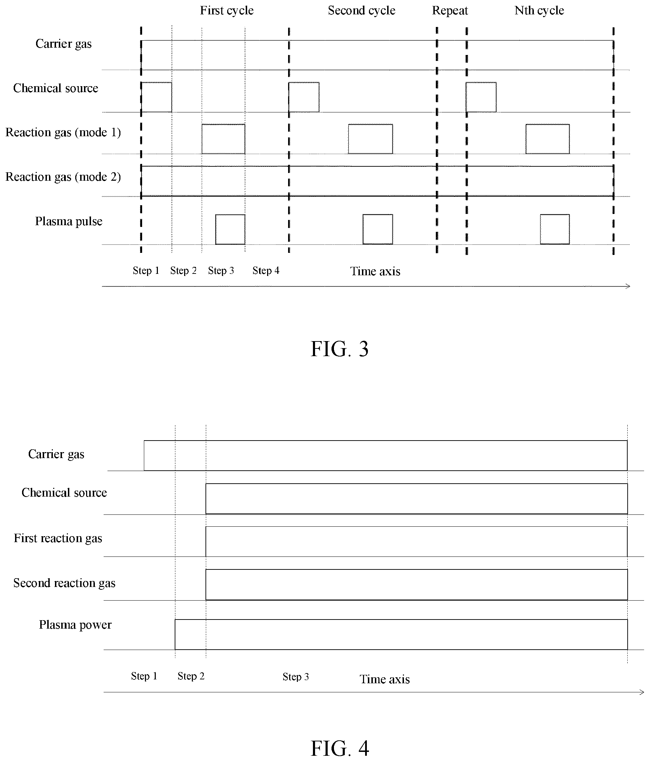

FIG. 3 is an operating diagram of a mode of each gas and chemical sources for the plasma-enhanced atomic layer deposition entering the chamber and a mode of feeding the plasma into the chamber.

An atomic layer deposition reaction includes several identical cycles, each of which ensures an atomic layer of the deposited thin film material. The number of the cycles can be controlled to accurately control the thickness of the thin film.

In each cycle, there are four steps:

Step 1, the first valve 1 and the second valve 2 are opened to cause the carrier gas 12 to flow through the chemical source 11 and enter the reaction chamber 6. A time of chemical source 11 entering the chamber (a pulse time of the chemical source) is controlled.

Step 2, the first valve 1 and the second valve 2 are closed, the third valve 3 is opened, and then the carrier gas 12 purges the reaction chamber.

Step 3, the fourth valve 4 and the fifth valve 5 are opened and the reaction gases are supplied, and then the plasma power supply is turned on for processing.

Step 4, the plasma power supply 9 is turned off, the third valve 3 is opened, and then the carrier gas 11 purges the reaction chamber 6.

The carrier gas 12 carries the chemical source 11 in two ways: when the first valve 1 and the second valve 2 are opened, by controlling the third valve 3, the carrier gas 11 may enter the chemical source 12 entirely and then enter the reaction chamber 6, or one part of the carrier gas 11 may enter the chemical source 12 and another part of the carrier gas 11 may directly enter the reaction chamber 6.

There are two ways of gas intake: the first way is a pulse type and the second way is a constant type. Both the first reaction gas and the second reaction gas can be fed in the two ways.

There are two modes of feeding the reaction gases into the chamber: either the open the fourth valve 4 and the fifth valve 5 throughout the cycle to make sure that the reaction gases can be consistently fed into the chamber, or feed the reaction gases into the chamber only in the third step. Since the reaction gases may react with the chemical source only in processing the plasma, the reaction gases together with the carrier gas can serve the purpose of purge in the absence of the plasma. Therefore, it should be noted that the reaction gases can be used as the carrier gas for the present device.

Specifically, taking the preparation of a thin film of alumina (Al₂O₃) as an example, the details therefor are set forth as follows:

Preparing a thin film of alumina with a thickness of 5 nm: taking a liquid trimethylaluminum (Al(CH3)₃) as a chemical source and storing it to a source bottle; taking argon (Ar) as a carrier gas, and carrying the Al(CH3)₃ vapor into a reaction chamber via a source bottle at a control flow rate of 5 SLM (standard liters per minute), while taking nitrous oxide (N₂O) as a reaction gas at a control flow rate of 0.5 SLM.

In one ALD cycle, supplying the Al(CH3)₃ for 5 seconds and then cutting it off; only supplying the Ar for 10 seconds of purge time; next, supplying the N₂O and turning on a plasma power source, and inputting the plasma power to the chamber for 5 seconds, and then cutting off the N₂O source and turning off the plasma power; continuously supplying the Ar for 10 seconds to complete the ALD cycle. A total cycle time is 30 seconds.

In each process of ALD cycle, the thin film of Al₂O₃ can be grown with a thickness of about 0.125 nm, so that a target thickness of 5 nm can be achieved for 1200 seconds during 40 cycles.

### Second embodiment:

The device is a reaction chamber for a plasma-enhanced chemical vapor deposition apparatus and performs a plasma-enhanced chemical vapor deposition reaction.

As shown in FIG. 4, FIG. 4 is an operational diagram of a mode of each gas and chemical source for plasma-enhanced chemical vapor deposition entering a chamber and a mode of feeding the plasma into the chamber.

What differs from the first embodiment lies in gas intake means. It can realize the plasma-enhanced chemical vapor deposition (PECVD) by feeding the first reaction gas 13, the second reaction gas 14 and the chemical source 11 in a stable way while keeping the plasma power source 9 normally turned on and maintaining a stable plasma.

Specifically, taking the preparation of a thin film of alumina (Al₂O₃) as an example and the details therefor are set forth as follows:

Preparing a thin film of alumina in thickness of 10 nm: taking a liquid trimethylaluminum (Al(CH3)₃) as a chemical source and storing it to a source bottle; taking argon (Ar) as a carrier gas, and carrying the Al(CH3)₃ vapor into a reaction chamber via the source bottle at a control flow rate of 5 SLM (standard liters per minute), while taking nitrous oxide (N₂O) as a reaction gas at a control flow rate of 0.5 SLM.

Firstly, feeding the Ar into the reaction chamber for 60 seconds; secondly, turning on the plasma power supply and inputting the plasma power to the chamber for 30 seconds; and finally, feeding the Al(CH3)₃ and N₂O simultaneously, and then starting to grow the thin film of Al₂O₃.

The thickness of the thin film can be controlled by controlling the inputting time of the plasma power. The Al₂O₃ deposition rate is typically about 0.05nm/s when using a low frequency (e.g., 40 kHz) plasma power supply, and a desired thickness can be achieved after growing 200 seconds.

## Claims

1. A reaction chamber for a vacuum reaction device, **characterized in that**, the reaction chamber is externally provided with a heater; a carrier is disposed in the reaction chamber on which an object to be coated is carried, and is electrically conductive and insulated from other portions in the reaction chamber; the carrier includes at least one set of plates arranged in parallel, and two adjacent plates are connected to two poles of a plasma power supply, respectively; one end of the reaction chamber is provided with a gas outlet connected to a vacuum pump, and another end of the reaction chamber is provided with a gas inlet connected to a gas source.

2. The reaction chamber for the vacuum reaction device according to claim 1, **characterized in that**, if the carrier is provided with at least two sets of parallel plates, the parallel plates are alternately connected to each other via conductive elements and are led out of a vacuum chamber, and connected to the two poles of the plasma power supply, respectively.

3. The reaction chamber for the vacuum reaction device according to claim 1, **characterized in that**, the gas source comprises a reaction gas, a vapor of a chemical source and a carrier gas; the reaction gas which are connected to the gas inlet through pipelines, respectively; the variety of the reaction gases is one, two or more; the variety of the chemical source is one, two or more; and the variety of the carrier gas is one, two or more.

4. The reaction chamber for the vacuum reaction device according to claim 3, **characterized in that**, a first valve is arranged between the gas inlet of the reaction chamber and the chemical source; a second valve is arranged between the chemical source and the carrier gas; a third valve is arranged between the gas inlet of the reaction chamber and the carrier gas; a fourth valve is arranged between the gas inlet of the reaction chamber and a first reaction gas; and a fifth valve is arranged between the gas inlet of the reaction chamber and a second reaction gas.

5. A vacuum reaction device, **characterized in that**, a reaction chamber of the vacuum reaction device employs the reaction chamber of claim 1, and the vacuum reaction device performs an atomic layer deposition reaction; a first valve is opened, a vapor of a chemical source enters the reaction chamber; or the first valve and a second valve are opened, a carrier gas enters the chemical source and carries the vapor of the chemical source into the reaction chamber; or the first valve, the second valve and a third valve are opened, the carrier gas partly carries the vapor of the chemical source into the reaction chamber; after the chemical source enters the reaction chamber and reacts therein and the carrier gas purges the reaction chamber, a fourth valve and/or a fifth valve are opened, a first reaction gas and/or a second reaction gas enter the reaction chamber, the plasma power supply is turned on, and a plasma is generated between two parallel plates of the carrier.

6. A vacuum reaction device, **characterized in that**, a reaction chamber of the vacuum reaction device employs the reaction chamber of claim 1, and the vacuum reaction device performs a chemical vapor deposition reaction; a first valve is opened, a vapor of a chemical source enters the reaction chamber; or the first valve and a second valve are opened, a carrier gas enters the chemical source and carries the vapor of a chemical source into the reaction chamber; or the first valve, the second valve and a third valve are opened, the carrier gas partly carries the vapor of the chemical source into the reaction chamber; in reaction processes, a fourth valve and/or a fifth valve are normally opened and the plasma power supply is normally turned on throughout a reaction cycle while a first reaction gas and/or a second reaction gas reacting with the chemical source.

7. A plasma-enhanced atomic layer deposition and coating method based on the vacuum reaction device of claim 5, **characterized in that**, the deposition method comprises a plurality of identical cycles, each cycle ensures deposition of a thin film material in a thickness with sub-nanometer level, and a thin film thickness is accurately controlled by controlling the number of the cycles;
each cycle comprises four steps:
all valves are closed prior to the start of process;
step 1, opening the first valve to cause the vapor of the chemical source to directly enter the reaction chamber; or opening the first valve and the second valve to cause the carrier gas flow through the chemical source and carry the vapor of the chemical source into the reaction chamber; or opening the first valve, the second valve and the third valve to cause a part of the carrier gas flow through the chemical source and carry the vapor of the chemical source into the reaction chamber; all of above means control a time of the chemical source entering the chamber by controlling opening and closing actions of the valves;
step 2, closing the first valve and the second valve and only opening the third valve, to cause the carrier gas which does not carry the chemical source to purge the reaction chamber, and controlling a purge time by controlling opening and closing actions of the third valve;
step 3, opening the fourth valve and/or the fifth valve to supply the reaction gas and subsequently turning on the plasma power supply to generate a plasma between parallel plates of the carrier, to cause the reaction gas to react with a surface of a substrate under the assistance of the plasma's energy; and controlling opening and closing actions of the fourth valve and/or the fifth valve to control a time of the reaction gas entering the reaction chamber;
step 4, closing the fourth valve and/or the fifth valve, turning off the plasma power supply, opening the third valve, and purging the reaction chamber with the carrier gas which does not carry the chemical source;
In the step 1 to the step 4, the fourth valve and/or the fifth valve may be normally opened to cause the reaction gas to consistently flow into the reaction chamber.

8. The plasma-enhanced atomic layer deposition and coating method according to claim 7, **characterized in that**, the carrier gas carries the chemical source in two ways: when the first valve and the second valve are opened, the third valve is closed, the carrier gas enters the chemical source entirely and then enters the reaction chamber, or the third valve is opened, one part of the carrier gas enters the chemical source and another part of the carrier gas directly enters the reaction chamber.

9. A plasma-enhanced chemical vapor deposition and coating method based on the vacuum reaction device of claim 6, **characterized in that**, simultaneously or separately supplying the chemical source and the reaction gas to the reaction chamber and turning on the plasma power supply to generate the plasma, supplying one part of the chemical source and the reaction gas to the reaction chamber and turning on the plasma power supply to generate the plasma, and then supplying another part of the chemical source and the reaction gas to the reaction chamber;
keeping corresponding valves open and keeping the chemical source and the reaction gas continuously entering the reaction chamber, keeping the plasma power supply continuously on to ensure that the plasma continuously exists between the parallel carriers, and controlling a turn-on time of the plasma power supply to control a thin film thickness.
